(19) **Europäisches Patentamt / European Patent Office / Office européen des brevets**

(11) **EP 4 016 367 A1**

(12) **EUROPEAN PATENT APPLICATION**

(43) Date of publication:
**22.06.2022 Bulletin 2022/25**

(21) Application number: **21212107.3**

(22) Date of filing: **02.12.2021**

(51) International Patent Classification (IPC):
**G06F 30/23** (2020.01)

(52) Cooperative Patent Classification (CPC):
**G06F 30/23;** F16H 55/17

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.12.2020 IT 202000029570**

(71) Applicant: **Gedy Trass S.r.l.**
**10128 Torino (IT)**

(72) Inventors:
• **ROSSO, Carlo**
**10128 Torino (IT)**
• **BRUZZONE, Fabio**
**10128 Torino (IT)**
• **MARCELLINI, Claudio**
**10128 Torino (IT)**
• **MAGGI, Tommaso**
**10128 Torino (IT)**

(74) Representative: **Mola, Edoardo**
**Praxi Intellectual Property S.p.A.**
**Corso Vittorio Emanuele II, 3**
**10125 Torino (IT)**

(54) **COMPUTATIONALLY EFFICIENT METHOD FOR OBTAINING PERFORMING GEARS**

(57) A computer implemented method comprising the steps of receiving a gear tooth load condition comprising a set of tooth loads and representing a meshing load over a mesh cycle; defining or receiving a reduced order 3D model of a gear comprising at least one tooth base, a tooth flank and tooth tip and including information of a full 3D model such as a total number N of gear teeth; determining z sets of reduced order model mass and stiffness parameters, wherein the z-th set refers to a z-th angular position of the model about an axis defining at least a portion of said tooth flank as an involute flank; and wherein the z sets comprise a Z1 set representing a first model angular position identifying the beginning of the mesh cycle and a Z set representing a second model angular position identifying the end of the mesh cycle; determining reduced order displacements, including tooth contact loss, and/or speeds and/or accelerations of model nodes by executing an iterative integration algorithm applied to said mass and stiffness parameters; wherein an expansion matrix is applied to said reduced order displacements and/or speeds and/or accelerations to obtain all DOF of said full 3D model; said full 3D model is rotated by 360°/N to obtain a rotated full 3D model and a reduction matrix is applied to the rotated full 3D model nodes to obtain a rotated reduced 3D model when a time iteration of the integration algorithm corresponds to said Z1 set at the beginning of the mesh cycle.

Fig. 2

**Description**

The present invention refers to a method for obtaining performing gears based on structural and dynamic analysis.

In order to provide dynamic parameters of meshing gears for a correct design and manufacturing process, it is known to either apply simple models that are quick but lack precision or to build 3D finite element models of the gears, which require long calculation time to provide accurate results.

The scope of the present invention is to provide precise dynamic parameters of a gear with a limited consumption of time and calculation power.

The scope of the present invention is achieved by a computer implemented method comprising the steps of

- Receiving a tooth load condition comprising a set of tooth loads and representing a meshing load over a mesh cycle
- Defining or receiving a reduced order 3D model of a gear comprising at least one tooth base, tooth flank and tooth tip, optionally also a gear rim and including information of a full 3D model such as a total number N of gear teeth
- Determining z sets of reduced order model mass and stiffness parameters, e.g. matrices, wherein the z-th set refers to a z-th angular position of the model about an axis defining at least a portion of said tooth flank as an involute flank; and wherein the z sets comprise a Z1 set representing a first model angular position identifying the beginning of the mesh cycle and a Z set representing a second model angular position identifying the end of the mesh cycle
- Determining reduced order displacements, including tooth contact loss, and/or speeds and/or accelerations of model nodes by executing an iterative integration algorithm e.g. a Newmark algorithm applied to said mass and stiffness parameters, wherein

  o an expansion matrix is applied to said reduced displacements and/or speeds and/or accelerations when a time iteration of the obtain all DOF of said full 3D model,
  o said full 3D model is rotated by 360°/N to obtain a rotated full 3D model and
  o a reduction matrix is applied to the rotated full 3D model nodes to obtain a rotated reduced 3D model when a time iteration of the integration algorithm corresponds to said Z1 set at the beginning of the mesh cycle,

  wherein the expansion and the reduction matrices are based on component mode synthesis transformation e.g. Craig-Bampton transformation and wherein after the time iteration where a mesh cycle ends, the next time iteration is a new mesh cycle where the rotated reduced 3D model is the reduced 3D model
- Calculate a dynamically variable quantity of the gear model such as but not limited to dynamic transmission error, dynamic stresses and strains e.g. in the tooth base region, dynamic loads on bearings, detailed fatigue cycle information, based on said reduced or expanded positions and/or speeds and/or accelerations.

In view of the adoption of an angular step based solution for the time iterations of the integration algorithm, it is possible to include quite complex load conditions during the mesh cycle and, at the same time, leverage on reduced order models to significantly decrease the computational time. It is therefore possible to obtain very precise results at a fraction of the time needed to run an always full 3D dynamic model. Such load conditions may be either applied as additional parameters in the model stiffness matrix or as external dynamic loads and/or dynamically changing supports conditions.

Once dynamically variable quantities are calculated, it is possible to visualize on a display and design the gears, tolerances etc. so as to produce the gears according to such quantities.

According to a preferred embodiment, the reduced order model is such to angularly cover an angular sector having the maximum number of teeth contacting at the same time with a meshing gear.

This is to define the mesh cycle. In case over the mesh cycle the number of meshing teeth changes, e.g. from 1 to 2 (or more than 2) to 1, it is possible to model del load accordingly based on the angular position(s) of the mesh cycle where the load is applied on 1 tooth and the angular position(s) of the mesh cycle where the load is applied on 2 teeth. Another important effect of the invention is that the computational size of the problem is defined by the mesh cycle and not by the actual dimension of the gear. This is of great importance where e.g. a big gear is analyzed. Indeed, in the extreme case where a very big gear e.g. in case of large wind turbines has a mesh cycle including 1 tooth only, the computation size of the problem, e.g. the dynamic problem solved iteratively, is delimited by the nodes necessary to model the single tooth. This provides a considerable step forward in analyzing those structures e.g. large gears that have considerable dynamic issues because of size. A comparable dynamic analysis including parameters that change over the mesh cycle via a full 3D mesh of the large gear would require weeks or months to be solved because of the extremely large number of nodes required to model the big-size gear.

The present invention will be described below by means of some preferred embodiments, provided by way of non-limiting example, with reference to the attached drawings. These drawings illustrate different aspects and examples of the present invention and, where appropriate, similar structures, components, materials and / or elements in different figures are indicated by similar reference numerals.

Fig. 1 shows an example of parametric mesh for FEM analysis of a portion of a gear
Fig. 2 shows a number of examples of gear portion models to model a contact region, with examples of different size of elements
Fig. 3 shows a plan view of a full FEM model of a gear to explain the invention
Fig. 4 shows a perspective view of fig. 3
Fig. 5 shows a step of angular displacement of the gear model according to the invention
Fig. 6 shows different angular steps of a portion of the gear model and the displacement of an elastic constraint placed on a flank of relevant teeth to model the interaction with the not-shown meshing gear
Fig. 7 shows a diagram of the mesh stiffness that changes over the mesh cycle

Model set-up

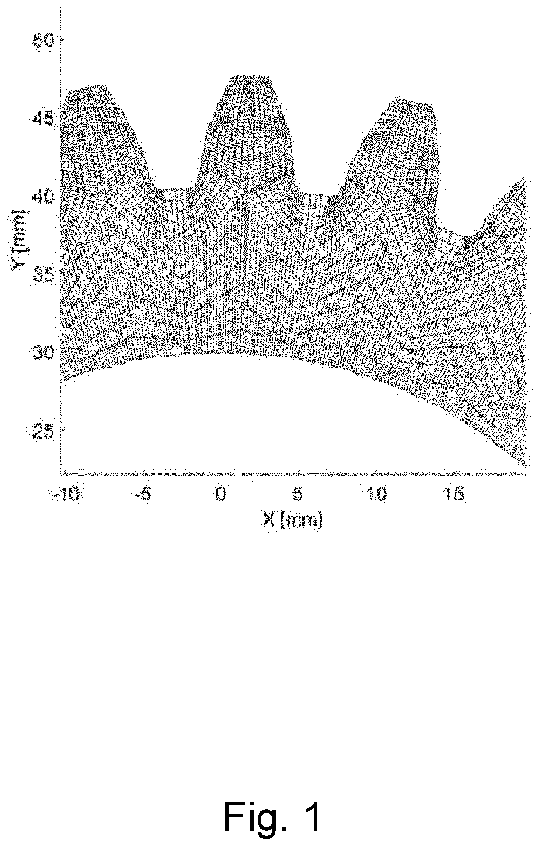

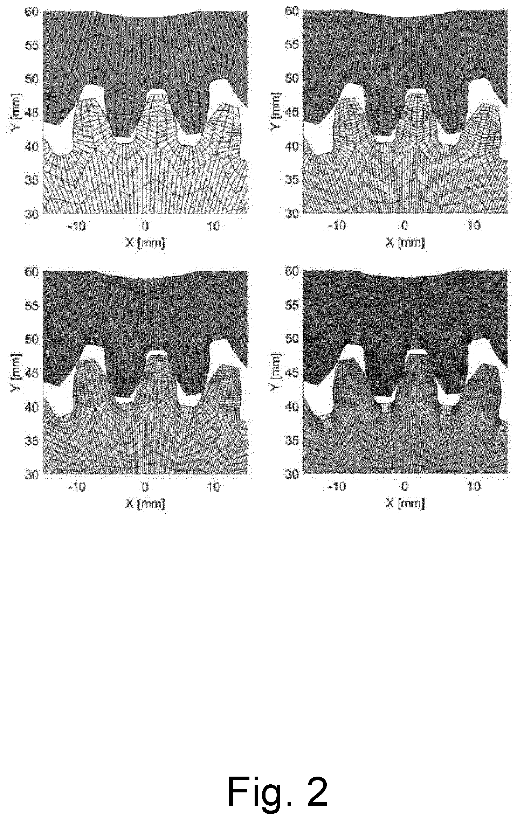

The first step is obtaining the mesh discretization as nodes and elements to be input to generate the required mass and stiffness matrices. This is done in a parametric way by separating the half-tooth region in its involute, fillet and web portions as visible in Figure 1. The number of nodes in each region can be controlled almost independently, except for the number of nodes in the thickness direction of the half tooth, which must be constant throughout the three regions to give continuity to the mesh. Through various parameters combinations different element sizes and densities can be obtained as visible in Figure 2. Next, a selection of the nodes on the entire inner radius region of the web is selected to be connected through a rigid joint connection to a central node. To do this, 6 rows and columns are added to the obtained matrices

$$K_f = \begin{bmatrix} K & 0_{n,6} \\ 0_{6,n} & 0_{6,6} \end{bmatrix}, M_f = \begin{bmatrix} M & 0_{n,6} \\ 0_{6,n} & 0_{6,6} \end{bmatrix} \qquad (1)$$

to leave space for an additional virtual node in the center of rotation of the gear, which will be the master node of this rigid joint connection, while the nodes on the inner radius will be the slaves, all connected to the same central master node. For each master-slave pair the rigid joint transformation matrix is computed as

$$\begin{Bmatrix} u_m \\ u_s \end{Bmatrix} = T_{rj} u_m = \begin{bmatrix} 1 & & \\ & 1 & \\ & & 1 \\ 0 & -\Delta z & +\Delta y \\ +\Delta z & 0 & -\Delta x \\ -\Delta y & +\Delta x & 0 \end{bmatrix} u_m \qquad (2)$$

where $u_m$ indicates the master node DOFs, while $u_s$ the slave ones. $\Delta x$, $\Delta y$ and $\Delta z$ are the distances between the $h^{th}$ slave node and the master central node. For each $h^{th}$ slave node considered a $T_{rj,h}$ transformation matrix is hence computed and assembled into the entire transformation matrix

$$T_{RJ} = \begin{bmatrix} I & 0 \\ 0 & T_{rj,1} \\ \vdots & \vdots \\ & T_{rj,h} \end{bmatrix} \qquad (3)$$

where $I$ is an identity matrix of suitable dimension.
The DOFs of matrices $K_f$ and $M_f$ are sorted placing first all DOFs that are not interested in this transformation ($u_{all}$), then the DOFs of the virtual node created which will be the master node ($u_t$) and lastly the h slave nodes in the same order as their transformation matrix has been placed in $T_{RJ}$. The matrices with the embedded rigid joint connection towards the central node are then simply obtained by

$$K_j = T_{RJ}^T K_f T_{RJ}, M_j = T_{RJ}^T M_f T_{RJ} \qquad (4)$$

3

The virtual node thus created, which connects all inner radius points selected to itself, will have three translational DOFs as well as three rotational DOFs. All those additional DOFs will be constrained, by deleting the appropriate rows and columns of the matrices, except for the rotational DOF around the Z axis, where the torque to the gear will be applied and the DTE will be read.

A reduced order model

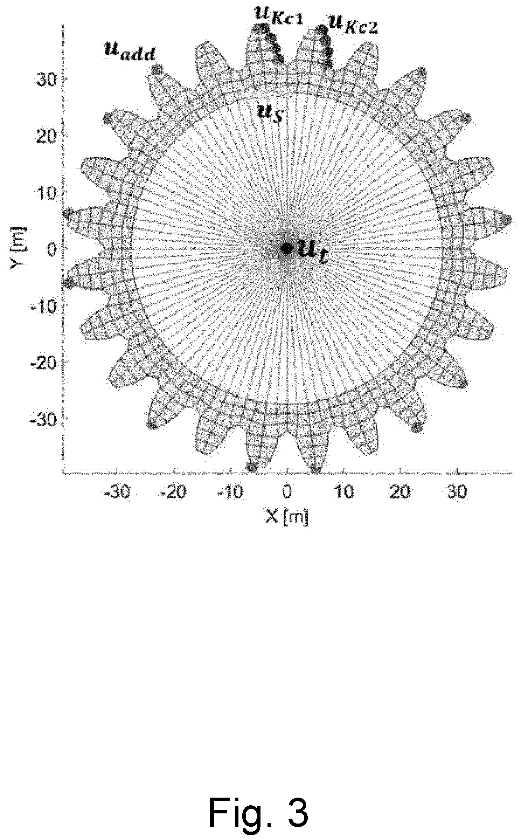

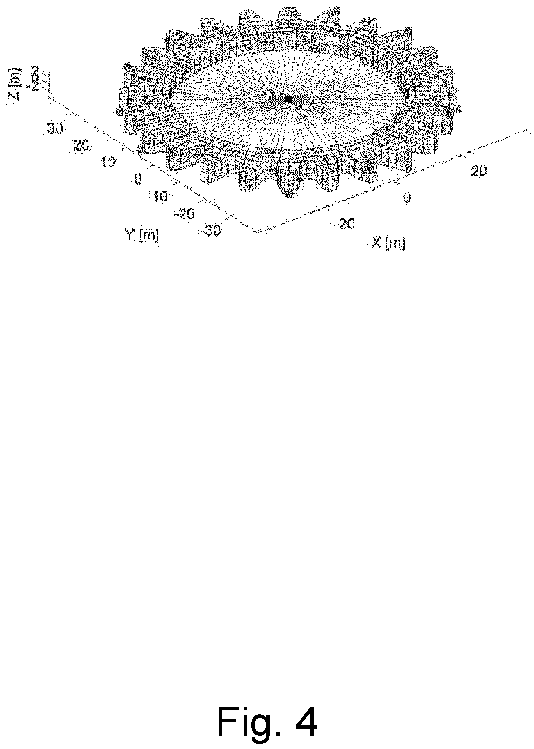

According to the invention, a Reduced Order Model is used in order to decrease the matrices sizes and reduce the otherwise impossibly long computational times. The idea is to exploit the periodic nature of the meshing action to obtain a ROM containing only the necessary DOFs to represent the interaction and the cyclical excitation that is typical of gears. The geometrical properties of a gear are also cyclically symmetric with a period angle $\theta$ = **360/Z** and so can be considered the properties of FE model. For example a force can be applied to any node on the flank of one teeth and results obtained, but if the same properly rotated force is applied to the homologous node on following or previous flank the results will be the same, except for a delay angle equal to $\pm\theta$. In the proposed approach this cyclic repletion will be exploited by reducing as much as possible the number of DOFs of the ROM by considering only a limited number of loaded or observed nodes to one sector spanning the angle $\theta$, while the typical travelling excitation wave will be created by expanding, sorting and reducing the obtained displacements, velocities and accelerations in the time domain each time the angle $\theta$ has been spanned. The master nodes, and their related DOFs are visible in Figure 3 and 4, and their meaning is as follows:

- Sensor nodes $u_s$ (green dots): The dynamic displacements of these nodes will be used to read and analyze the dynamic response of the gear in the radial and axial directions, simulating the behavior of a proximity sensor in an experimental test. For this reason, a number of them is needed, enough to span the angle $\theta$. How a single displacement is obtained from all those nodes will be detailed later. Such nodes are optional.
- Contact mesh stiffness nodes $u_{Kc1}, u_{Kc2}$ (blue dots) : The source of excitation i.e. the load of the whole system will be the periodic variation of the location of the connection point of the contact stiffness and also its intensity. All nodes pertaining to the flank at a determined axial coordinate are selected and two teeth are needed to model LCRG (Low Contact Ratio Gears), while three or more would be needed to model HCRG (High Contact Ratio Gears) .
- Additional nodes $u_{add}$ (orange dots): Those nodes are selected thanks to a Modal-Geometrical Selection Criterion (MoGeSeC) in order to select the nodes where the most modal content is located as visible in Figures 3 and 4 to improve the accuracy of the ROM. These are not strictly needed since they won't play any part in the calculations and could be avoided in order to further reduce the matrices dimensions, at a cost in accuracy.
- Central node $u_t$ (black dot): This node is the master node of the rigid joint connection, linking the selected nodes on the inner radius to itself as describe earlier. The torque will be applied on the rotational DOF left unconstrained and its displacement will be taken as the output Dynamic Transmission Error from the time domain response, imitating the readout of an angular encoder. Another example of a dynamic parameter that can be calculated according to the present invention is the constraint load of bearings. Such load is represented by the force experienced by the bearing nodes.

Hence, the final vector of the master DOFs is assembled as (including the optional additional nodes and sensor nodes):

$$u_m = \left\{ u_S^T \ u_{Kc1}^T u_{Kc2}^T \ u_{add}^T \ u_t^T \right\}^T \qquad (5)$$

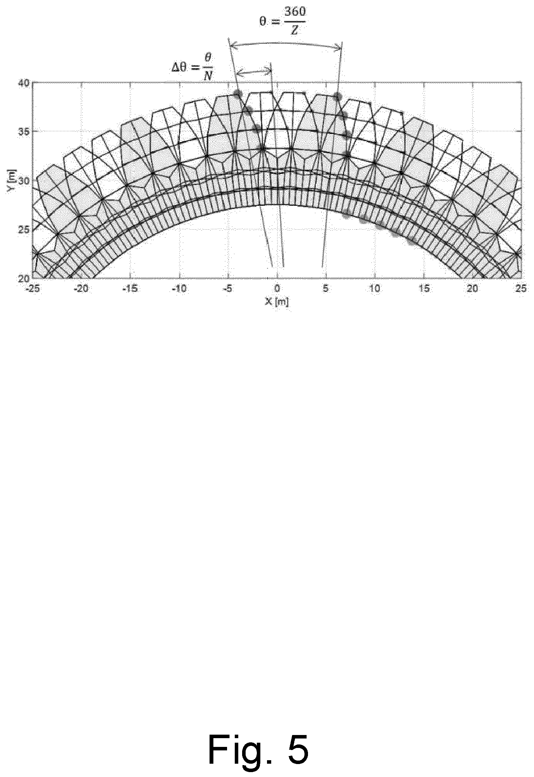

The angular step approach
In order to use always the same set of master DOFs and to describe the meshing process taking place in a meshing cycle a set of matrices, each rotated of a small angle $\Delta\theta = \theta/N$, is first obtained, where **N** is the number subdivisions of the mesh cycle chosen as visible in Figure 5. This will imply that the angular distance covered between each time step will be $\Delta\theta$ and hence the interval $\Delta t$ between the successive time instants will vary with the speed. Given a starting rotational velocity $\Omega_s$ and a final one $\Omega_f$ the constant angular acceleration is simply obtained by

$$\dot{\Omega} = \frac{\Omega_f - \Omega_s}{t} \qquad (6)$$

where **t** is the total time in which the speed sweep will happen. The instantaneous rotational velocity $\Omega_i$ at a generic time instant $t_i$ is obtained by

$$\Omega_i = \Omega_{i-1} + \dot{\Omega}(t_i - t_{i-1}) \qquad (7)$$

where

$$t_i = t_{i-1} + \frac{\Omega_{i-1} + \sqrt{\Omega_{i-1}^2 + 2\Delta\theta\dot{\Omega}}}{\dot{\Omega}} \qquad (8)$$

It is important to note that time consistency is important in order to precisely reproduce the meshing process and the dynamic simulation that will be discussed later. The matrices at each angular position in the mesh cycle are obtained by matrix rotation, in which the nodal rotation matrix for a generic node is

$$R_{\Delta\theta,i} = \begin{bmatrix} \cos(\Delta\theta \cdot (z-1)) & \sin(\Delta\theta \cdot (z-1)) & 0 \\ -\sin(\Delta\theta \cdot (z-1)) & \cos(\Delta\theta \cdot (z-1)) & 0 \\ 0 & 0 & 1 \end{bmatrix} \qquad (9)$$

where **z = 1,2,..,N** which are then assembled on the diagonal of the full rotation matrix $R_{\Delta\theta,z}$ of suitable dimension to perform matrix rotation as

$$K_z = R_{\Delta\theta,z}^T K_j R_{\Delta\theta,z}, M_z = R_{\Delta\theta,z}^T M_j R_{\Delta\theta,z} \qquad (10)$$

For each of those matrices a Craig-Bampton (CB) Component Mode Synthesis (CMS) is obtained, alternatives of lumping algorithms being the family of component node synthesis transformation including e.g. MCMS,Complex CMS, Hybrid CB, SEREP. First matrices are partitioned by separating the masters and slaves DOFs as

$$\begin{bmatrix} M_{mm} & M_{ms} \\ M_{sm} & M_{ss} \end{bmatrix} \begin{Bmatrix} \ddot{u}_m \\ \ddot{u}_s \end{Bmatrix} + \begin{bmatrix} K_{mm} & K_{sm} \\ K_{sm} & K_{ss} \end{bmatrix} \begin{Bmatrix} u_m \\ u_s \end{Bmatrix} = \begin{Bmatrix} f_m \\ f_s \end{Bmatrix} \qquad (11)$$

The transformation matrix of the CB-CMS $T_{cb}$ is obtained by

$$\begin{Bmatrix} u_m \\ u_s \end{Bmatrix} = T_{cb,z} \begin{Bmatrix} u_m \\ q_m \end{Bmatrix} = \begin{bmatrix} I & 0 \\ \Psi_c & \Phi_l \end{bmatrix} \begin{Bmatrix} u_m \\ q_m \end{Bmatrix} \qquad (12)$$

where $\Psi_c$ is the static part of the reduction

$$\Psi_c = -K_{ss}^{-1} K_{sm} \qquad (13)$$

And $\Phi_l$ is the matrix of eigenvectors $\phi_i$ obtained by modal analysis on the equivalent matrices where the master DOFs are constrained, i.e. by keeping only the rows and columns pertaining to the slave DOFs $u_s$

$$\Phi_l = \begin{bmatrix} \varphi_1 & \cdots & \phi_i & \cdots & \phi_{nm} \end{bmatrix} \qquad (14)$$

The CB-CMS mass matrix for the $z^{th}$ angular position is then obtained as

$$M_z^r = T_{cb,z}^T M_z T_{cb,z} \qquad (15)$$

and similarly for the $z^{th}$ stiffness matrix

$$K_z^r = T_{cb,z}^T K_z T_{cb,z} \qquad (16)$$

Alternatively, for faster computation, the reduced matrices can be obtained by calculating separately their components, namely for the mass matrix

$$M_z^r = \begin{bmatrix} M_{mm} + \Psi_c^T M_{ss} \Psi_c & \Psi_c^T M_{ss} \Phi_l \\ [\Psi_c^T M_{ss} \Phi_l]^T & I \end{bmatrix} \qquad (17)$$

and for the stiffness matrix

$$K_z^r = \begin{bmatrix} K_{mm} + K_{ms} \Psi_c & 0 \\ 0 & \omega_l \end{bmatrix} \qquad (18)$$

Where $\omega_l$ are the corresponding eigenvalues to the eigenvectors $\Phi_l$. The damping model chosen is proportional Rayleigh damping of the form

$$C_z = \alpha_c M_z + \beta_c K_z \qquad (19)$$

Where the values of $\alpha_c$ and $\beta_c$ will be detailed later, while the reduced matrix is again obtained as

$$C_z^r = T_{cb,z}^T C_z T_{cb,z} \qquad (20)$$

All $K_z^r$, $C_z^r$, $M_z^r$ matrices are obviously saved to be used in the integration scheme, while all others are discarded, except for the following ones:

- The rotation matrix of the angle $\Delta\theta$

$$R_{\Delta\theta} = \begin{bmatrix} \begin{bmatrix} \cos(\Delta\theta) & \sin(\Delta\theta) & 0 \\ -\sin(\Delta\theta) & \cos(\Delta\theta) & 0 \\ 0 & 0 & 1 \end{bmatrix} & & \\ & \ddots & \\ & & \begin{bmatrix} \cos(\Delta\theta) & \sin(\Delta\theta) & 0 \\ -\sin(\Delta\theta) & \cos(\Delta\theta) & 0 \\ 0 & 0 & 1 \end{bmatrix} \end{bmatrix} \qquad (21)$$

- The matrix that will be used to expand the displacements, velocities and accelerations once $z = N$

$$T_{cb,N} \qquad (22)$$

- The reduction matrix that will be used to reduce the displacements, velocities and accelerations to begin the new mesh cycle for $z = 1$

$$T_{r,1} = (T_{cb,1}^T T_{cb,1}) T_{cb,1}^T \qquad (23)$$

whose application will be explained later.

This preprocessing step is computationally heavy, in particular because of equation (13) but it can be performed only once if the macro-geometrical parameters of the considered gear do not change.

Iterative integration of the reduced order model with variable time step

Once this macro-step is completed, the iterative integration scheme can proceed, which is based for example on a Newmark scheme with constant acceleration. The constants used are

$$\alpha_{NM} = \frac{1}{4}, \delta_{NM} = \frac{1}{2} \qquad (24)$$

In the Newmark integration scheme, regrouping the terms of the equation of motion to be solved the following expression is obtained for the $i^{th}$ time step, which corresponds to the $z^{th}$ angular position

$$\ddot{u}^*_{\ i} = S_i \delta r_i \qquad (25)$$

where

$$S_i = M^r_{z,i} + \Delta t_i C^r_{z,i} + \Delta t_i^2 \alpha_{NM} \big( K^r_{z,i} + K^r_{c,i} \big) \qquad (26)$$

Where the time interval $\Delta t_i$ changes from step to step because of angular speed change as defined in eq. 8. The residual vector $\delta r_i$ is obtained from the following matrices

$$D_i = -\big( K^r_{z,i} + K^r_{c,i} \big)$$

$$V_i = -C^r_{z,i} - \Delta t_i \big( K^r_{z,i} + K^r_{c,i} \big) \qquad (27)$$

$$A_i = -C^r_{z,i}(1 - \delta_{NM})\Delta t_i - \big( K^r_{z,i} + K^r_{c,i} \big) \left( \frac{1}{2} - \alpha_{NM} \right) \Delta t_i^2$$

which are then assembled as

$$\delta r_i = f + D_i u_{i-1} + V_i \dot{u}_{i-1} + A_i \ddot{u}_{i-1} \qquad (28)$$

Where $u_{i-1}$, $\dot{u}_{i-1}$, $\ddot{u}_{i-1}$ are respectively the displacements, velocities and accelerations vectors at the previous time step. The external force vector $f$ will be considered for example constant throughout the entirety of simulation and its only non-null value will be the torque $T$ applied to the only free DOF of the central master node of the rigid joint connection. The acceleration at the current time step is then computed as

$$\ddot{u}^*_{\ i} = S_i^{-1} \delta r_i \qquad (29)$$

Using this acceleration vector and the displacements, velocities and accelerations of the previous step the new ones can then be computed, namely for the velocities

$$\dot{u}^*_{\ i} = \dot{u}_{i-1} + (1 - \delta_{NM}M)\ddot{u}_{i-1} + \delta_{NM}\ddot{u}^*_{\ i}\Delta t_i \qquad (30)$$

And for the displacements

$$u^*_{\ i} = u_{i-1} + \Delta t_i \dot{u}_{i-1} + \Delta t_i^2 \left( \frac{1}{2} - \alpha_{NM} \right) \ddot{u}_{i-1} + \alpha_{NM}\ddot{u}^*_{\ i}\Delta t_i^2 \qquad (31)$$

The displacements, velocities and accelerations $u^*_{\ i}, \dot{u}^*_{\ i}, \ddot{u}^*_{\ i}$ thus obtained are marked by the apex * since they have been obtained with the $z^{th}$ rotated matrices along the mesh cycle, but for the next time step the $(z+1)^{th}$ matrices will have to be used. Since the only difference between the two sets of matrices is a rigid rotation of $\Delta\theta$, the same rotation will be applied to the current results to obtain a suitable set of inputs for the next time step as

$$u_i = R_{\Delta\theta}u^*_i \,, \dot{u}_i = R_{\Delta\theta}\dot{u}^*_i \,, \ddot{u}_i = R_{\Delta\theta}\ddot{u}^*_i \tag{32}$$

Reset of the initial condition at the end of the mesh cycle

Such iterative time advancement can continue for each $z^{th}$ angular position of the mesh cycle, until **z = N** when special measures have to be taken since the cycle has to be reset to its initial condition, while keeping the travelling wave of excitation continuous. To do so, the displacements, velocities and accelerations obtained for the $i^{th}$ time step where **z = N** are first expanded to obtain again the values for all DOFs of the full FE model. This is done by employing the saved $T_{cb,N}$ as

$$u_{i,F} = \begin{Bmatrix} u_m \\ u_s \end{Bmatrix} = T_{cb,N}u_i \,, \dot{u}_{i,F} = \begin{Bmatrix} \dot{u}_m \\ \dot{u}_s \end{Bmatrix} = T_{cb,N}\dot{u}_i \,, \ddot{u}_{i,F} = \begin{Bmatrix} \ddot{u}_m \\ \ddot{u}_s \end{Bmatrix}$$
$$= T_{cb,N}\ddot{u}_i \tag{33}$$

where the subscript **F** indicates that they represent the full FE model. Then the obtained vectors are sorted so that for the next mesh cycle the master DOFs selected will be the ones geometrically corresponding to ones of the last cycle, but with an angular difference of $\theta$ = **360/Z,** meaning that that the homologous nodes currently selected will be taken on the next tooth, following the sense of rotation. Thus, the same geometrical points will be chosen, but advanced of one tooth and then the new set of displacements, velocities and accelerations, sorted in this new configuration, is reduced using the reduction matrix for **z = 1**

$$u_{i,F} = T_{r,1}u'_{i,f} = T_{r,1}\begin{Bmatrix} u'_m \\ u'_s \end{Bmatrix}$$
$$\dot{u}_{i,F} = T_{r,1}\dot{u}'_{i,f} = T_{r,1}\begin{Bmatrix} \dot{u}'_m \\ \dot{u}'_s \end{Bmatrix} \tag{34}$$
$$\ddot{u}_{i,F} = T_{r,1}\ddot{u}'_{i,f} = T_{r,1}\begin{Bmatrix} \ddot{u}'_m \\ \ddot{u}'_s \end{Bmatrix}$$

Where $\begin{Bmatrix} u'_m \\ u'_s \end{Bmatrix}$, $\begin{Bmatrix} \dot{u}'_m \\ \dot{u}'_s \end{Bmatrix}$, $\begin{Bmatrix} \ddot{u}'_m \\ \ddot{u}'_s \end{Bmatrix}$ are the newly sorted sets of masters and slaves DOFs. In this way the cycle can begin again with **z = 1** and the **(i+1)**$^{th}$ time step can be computed, while this process is repeated each time that **z = N** resetting then the counter to **z = 1** until the completion of all required time steps.

The force vector: example of parametric excitation

As stated, the external force vector **f** will be considered constant throughout the entire simulation, but the excitation of the dynamic system comes from the time-varying and moving contact mesh stiffness $K^r_{c,i}$ which acts upon the DOFs $u_{Kc1}$ and $u_{Kc2}$ of the two teeth pairs considered as in Figures 3 and 4 in the reduced matrices. The time-varying contact mesh stiffness is simulated by a grounded spring whose matrix form is

$$K_{cm} = c_n k_{p,i} \begin{bmatrix} cos(\alpha) & 0 & 0 \\ 0 & sin(\alpha) & 0 \\ 0 & 0 & 0 \end{bmatrix} \tag{35}$$

wherein $k_{p,i}$ is the instantaneous value of the mesh contact stiffness at time i for tooth pair $p$ and $c_n$ is a weight coefficient which changes from 0 to 1 and is different for each node considered, and $\alpha$ is the pressure angle. At the **z**$^{th}$ angular position the location of the contact point is known e.g. via a method according to WO-A1-2019142140, which provides a very detailed set of inputs representing a contact model between gear teeth, and contact point location is compared to the coordinates of the $n^{th}$ selected node on the flank for the reduced systems: if the location of the contact point coincides with one of the selected nodes then the corresponding coefficient is set to one and all others are set to zero, while if the contact point lies between two nodes the coefficient linearly varies similarly to 1D shape functions as

$$c_{n-1} = \frac{x_n - x}{x_n - x_{n-1}} \ , c_n = \frac{x_{n-1} - x}{x_n - x_{n-1}} \tag{36}$$

where $x_n$ is the pseudo coordinate of the node on the flank as seen on a line, and this verifies $\sum_{n=1}^{mn} c_n = 1$ for every angular position considered, where $mn$ is the number of mesh nodes selected on the flank to which the DOFs $u_{Kc1}$ or $u_{Kc2}$ correspond. Therefore, to simulate both the time variation of the value of the contact stiffness due to the meshing interaction and the motion of said stiffness along the flank as it varies during the mesh cycle, for every $i^{th}$ time instant the matrices are assembled placing the grounded springs on the DOFs related for each of the considered nodes on the flank, so for the first tooth pair the matrices are placed on the DOFs of $u_{Kc1}$

$$K_{1,i}^r =$$

$$= \begin{bmatrix} \ddots & & & \\ & c_1 k_{1,i} \begin{bmatrix} cos(\alpha) & 0 & 0 \\ 0 & sin(\alpha) & 0 \\ 0 & 0 & 0 \end{bmatrix} & & \\ & & \ddots & \\ & & & c_{mn} k_{1,i} \begin{bmatrix} cos(\alpha) & 0 & 0 \\ 0 & sin(\alpha) & 0 \\ 0 & 0 & 0 \end{bmatrix} \\ & & & & \ddots \end{bmatrix} \tag{37}$$

And for the second one

$$K_{2,i}^r =$$

$$= \begin{bmatrix} \ddots & & & \\ & c_1 k_{2,i} \begin{bmatrix} cos(\alpha) & 0 & 0 \\ 0 & sin(\alpha) & 0 \\ 0 & 0 & 0 \end{bmatrix} & & \\ & & \ddots & \\ & & & c_{mn} k_{2,i} \begin{bmatrix} cos(\alpha) & 0 & 0 \\ 0 & sin(\alpha) & 0 \\ 0 & 0 & 0 \end{bmatrix} \\ & & & & \ddots \end{bmatrix} \tag{38}$$

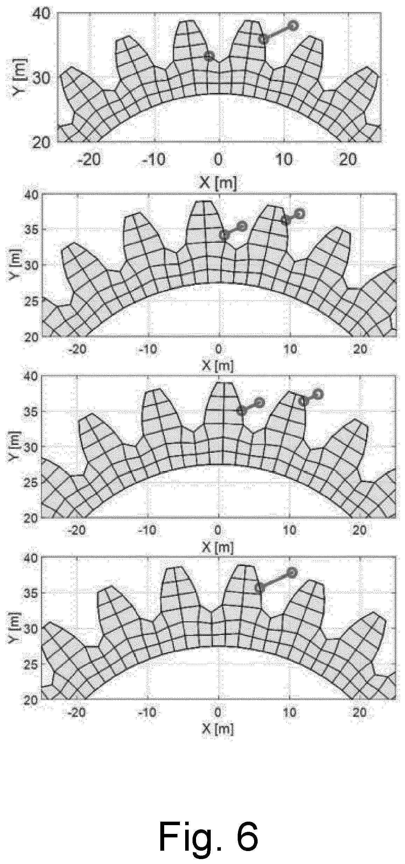

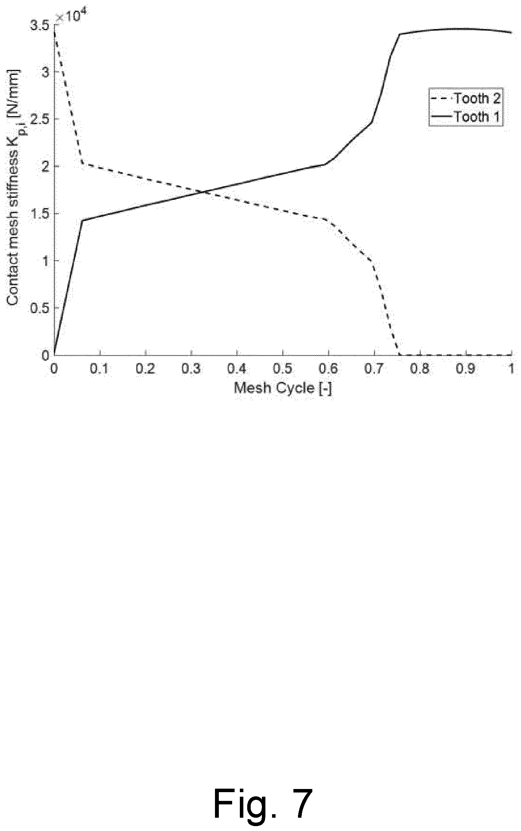

A visualization of the motion of the contact mesh stiffness and its variation in a mesh cycle using this method is visible in Figure 6 and exemplary values of the contact mesh stiffness are shown in figure 7.

Clearly this approach can be easily extended for gears with contact ratio greater than 2 with minimal modifications in the process. A similar approach is used to simulate the readout of a proximity sensor on the edge of the rim where the nodes corresponding to the DOFs $u_s$ of the selected sensor nodes. Since a proximity sensor is fixed at a predetermined angular position the response must be read at the same location for every time step and angular position during rotation. To do so the displacements $\{u_s, v_s, w_s\}^T$ of each of the s selected sensor nodes is used to compute the displacements at a fixed point by

$$u_i = \sum_{n=1}^{s} c_s u_s \ , v_i = \sum_{n=1}^{s} c_s v_s \ , w_i = \sum_{n=1}^{s} c_s w_s, \tag{39}$$

where $c_s$ are weights computed in a similar way of $c_n$ only in this case the angular distance between the wanted read angle $\Psi$ and the instantaneous position of the $s^{th}$ sensor node is considered to assign the weight to each of the obtained displacements from the sensor nodes. Similarly, using the weights $c_n$ and the displacements of the nodes where the contact mesh stiffness is applied the dynamic mesh deflection can be obtained along the direction of application of the load for each loaded tooth. This dynamic mesh deflection is obtained at each time step for each considered tooth and is positive if the grounded spring simulating the contact mesh stiffness is compressed, while negative if it's working in traction. If such situation occurs, for the next time step the instantaneous value of the contact mesh stiffness $k_{p,i}$ is set to 0 thus simulating a partial or total contact loss in the mating teeth, depending on how many teeth have a negative dynamic mesh deflection. In the next paragraphs the proposed model will be applied to a gear first with a rigid web and later to one with a compliant one. Further effects will be introduced along the way and the effect of several parameters will be investigated. However, as will be shown, due to the combination of geometry, parameters and loads no contact loss has been detected in any of the proposed tests.

**Claims**

1. A computer implemented method comprising the steps of

   - Receiving a gear tooth load condition comprising a set of tooth loads and representing a meshing load over a mesh cycle
   - Defining or receiving a reduced order 3D model of a gear comprising at least one tooth base, tooth flank and tooth tip and including information of a full 3D model such as a total number N of gear teeth
   - Determining z sets of reduced order model mass and stiffness parameters, wherein the z-th set refers to a z-th angular position of the model about an axis defining at least a portion of said tooth flank as an involute flank; and wherein the z sets comprise a Z1 set representing a first model angular position identifying the beginning of the mesh cycle and a Z set representing a second model angular position identifying the end of the mesh cycle
   - Determining reduced order displacements, including tooth contact loss, and/or speeds and/or accelerations of model nodes by executing an iterative integration algorithm applied to said mass and stiffness parameters, wherein

     ○ an expansion matrix is applied to said reduced order displacements and/or speeds and/or accelerations to obtain all DOF of said full 3D model
     ○ said full 3D model is rotated by 360°/N to obtain a rotated full 3D model and
     ○ a reduction matrix is applied to the rotated full 3D model nodes to obtain a rotated reduced 3D model when a time iteration of the integration algorithm corresponds to said Z1 set at the beginning of the mesh cycle,

     wherein the expansion and the reduction matrices are based on component mode synthesis transformation and wherein after the time iteration where a mesh cycle ends, the next time iteration is a new mesh cycle where the rotated reduced 3D model is the reduced 3D model
   - Calculating a dynamically variable quantity of the gear model based on said reduced order or expanded order displacements and/or speeds and/or accelerations

2. Method according to claim 1, wherein the dynamically variable quantity includes at least one of a dynamic transmission error, dynamic stresses and strains, dynamic loads on bearings, fatigue cycle information.

3. Method according to claim 1, further comprising the step of manufacturing a gear based on said dynamically variable quantity.

4. Method according to claim 1, further comprising the step of visualizing on a display the model.

Fig. 1

Fig. 2

Fig. 3

Fig. 4

Fig. 5

Fig. 6

Fig. 7

Europäisches
Patentamt

European
Patent Office

Office européen
des brevets

# EUROPEAN SEARCH REPORT

Application Number

**EP 21 21 2107**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TUGAN ERITENEL ET AL: "An investigation of tooth mesh nonlinearity and partial contact loss in gear pairs using a lumped-parameter model", MECHANISM AND MACHINE THEORY, PERGAMON, AMSTERDAM, NL, vol. 56, 7 May 2012 (2012-05-07), pages 28-51, XP028402479, ISSN: 0094-114X, DOI: 10.1016/J.MECHMACHTHEORY.2012.05.002 [retrieved on 2012-05-15] * pages 28-51 * ----- | 1-4 | INV. G06F30/23 |
| A | CN 108 052 760 A (CHANGAN UNIV) 18 May 2018 (2018-05-18) * pages 2-10 * ----- | 1-4 | |
| A | US 2013/085722 A1 (JAMES BARRY [GB]) 4 April 2013 (2013-04-04) * pages 1-9 * ----- | 1-4 | |
| A | LIN ET AL: "A finite element method for 3D static and dynamic contact/impact analysis of gear drives", COMPUTER METHODS IN APPLIED MECHANICS AND ENGINEERING, NORTH-HOLLAND, AMSTERDAM, NL, vol. 196, no. 9-12, 23 December 2006 (2006-12-23), pages 1716-1728, XP005734809, ISSN: 0045-7825, DOI: 10.1016/J.CMA.2006.09.014 ----- | 1-4 | TECHNICAL FIELDS SEARCHED (IPC) G06F F16H |

The present search report has been drawn up for all claims

| Place of search | Date of completion of the search | Examiner |
|---|---|---|
| Munich | 16 May 2022 | Ismail, Youssef |

EPO FORM 1503 03.82 (P04C01)

## ANNEX TO THE EUROPEAN SEARCH REPORT
## ON EUROPEAN PATENT APPLICATION NO.

EP 21 21 2107

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2022

| Patent document cited in search report | | Publication date | Patent family member(s) | | | Publication date |
|---|---|---|---|---|---|---|
| CN 108052760 | A | 18-05-2018 | NONE | | | |
| US 2013085722 | A1 | 04-04-2013 | DE | 202013012661 | U1 | 22-03-2018 |
| | | | US | 2013085722 | A1 | 04-04-2013 |
| | | | US | 2015347670 | A1 | 03-12-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019142140 A1